**Europäisches Patentamt**

**European Patent Office**

**Office européen des brevets**

(11) Veröffentlichungsnummer: **0 501 016 A1**

# (12) EUROPÄISCHE PATENTANMELDUNG

(21) Anmeldenummer: **91118409.1**

(22) Anmeldetag: **29.10.91**

(51) Int. Cl.5: **C23C 14/34**, C23C 14/54

(30) Priorität: **01.03.91 DE 4106513**

(43) Veröffentlichungstag der Anmeldung:
**02.09.92 Patentblatt 92/36**

(84) Benannte Vertragsstaaten:
**BE CH DE FR GB IT LI NL**

(71) Anmelder: **LEYBOLD AKTIENGESELLSCHAFT**
**Wilhelm-Rohn-Strasse 25, Postfach 1555**
**W-6450 Hanau am Main 1(DE)**

(72) Erfinder: **Latz, Rudolf, Dr.**
**Spessartring 15**
**W-6054 Rodgau 2(DE)**

(54) Verfahren zur Regelung eines reaktiven Sputterprozesses und Vorrichtung für die Durchführung des Verfahrens.

(57) Es wird ein Verfahren zur Regelung eines reaktiven Sputterprozesses vorgeschlagen, bei dem durch den Wert einer der beiden die elektrische Leistungsaufnahme des reaktiven Sputterprozesses bestimmenden Faktoren, Arbeitsspannung oder Arbeitsstromstärke, definierte Arbeitspunkt auf der physikalischen Kennlinie Katodenspannung, bzw. Arbeitsstromstärke, über Reaktivgasfluss der Sputteranlage durch Dosierung des in die Prozesskammer eingeleiteten Reaktivgases, beispielsweise $O_2$, eingestellt und konstant gehalten wird. Weiterhin wird eine Vorrichtung zur Durchführung dieses Verfahrens vorgeschlagen, bei der eine Sputteranlage vorgesehen ist, die eine Regeleinrichtung (Reaktivgasregler) (5) und ein Regelventil (8) für die Dosierung des Reaktivgases umfasst, bei der weiterhin eine Signalleitung (15) vorgesehen ist, die die Katodenspannung zum Eingang der Regeleinrichtung führt, bei der der Ausgang der Regeleinrichtung mit dem Regelventil über eine Leitung (16) verbunden ist, die die Stellgröße, die in der Regeleinrichtung erarbeitet wurde, dem Regelventil zuführt.

FIG.1

Die Erfindung betrifft ein Verfahren zur Regelung eines reaktiven Sputterprozesses, wie er beispielsweise in der Beschichtungstechnik mit Katodenzerstäubung angewendet wird.

Es werden reaktionsfähige Gase, wie $O_2$, $N_2$, $CH_4$, $H_2S$ u.a. eingesetzt. Beim Beschichtungsprozess entstehen die entsprechenden Verbindungen: Oxide, Nitride, Carbide oder Sulfide, die als Schichten auf einem Substrat aufgetragen werden. Dieser reaktive Zerstäubungsprozess hat sich in der Fertigungstechnik sehr bewährt. Er hat u.a. den Vorteil, daß er die Herstellung von chemischen Verbindungen reproduzierbar macht. Rein beispielhaft sei erwähnt, daß mit derartigen reaktiven Sputterprozessen transparente leitende Schichten für Flüssig-Kristall-Anzeigen (LCD = Liquid Crystal Display) hergestellt werden.

Man kennt eine Gleichspannungszerstäubung und eine Hochfrequenzzerstäubung sowie Mischformen. Außerdem ist Sputtern mit Bias (Vorspannung) bekannt. Dabei werden Substrate auf einen elektrisch isolierten Substratträger gelegt, der eine, verglichen mit der Katode, kleine negative Vorspannung hat.

Die Gleichspannungszerstäubung ist auf elektrisch leitende Materialien als Katode (Target) beschränkt, da bei nicht leitender Katode der Strom durch den Isolator unterbrochen ist.

Die erwähnte Hochfrequenzzerstäubung wird benutzt, um auch Isolatoren zu zerstäuben. Die Elektroden der Sputteranlage werden dabei durch eine Hochfrequenz-Quelle versorgt.

Bei Zerstäubungsprozessen werden in der Praxis u.a. solche Hochleistungszerstäubungsvorrichtungen eingesetzt, bei denen durch ein Magnetfeld vor der Katode die Kollisions- und damit Ionisationswahrscheinlichkeit der Teilchen erhöht wird.

Eine derartige Hochleistungszerstäubungsvorrichtung wird beispielsweise in der deutschen Patentschrift 2417288 beschrieben.

Dort wird eine Katodenzerstäubungsvorrichtung mit hoher Zerstäubungsrate mit einer Katode, die auf einer ihrer Oberflächen das zu zerstäubende und auf einem Substrat abzulagernde Material aufweist, mit einer derart angeordneten Magneteinrichtung, daß von der Zerstäubungsfläche ausgehende und zu ihr zurückkehrende Magnetfeldlinien einen Entladungsbereich bilden, der die Form einer in sich geschlossenen Schleife hat, und mit einer außerhalb der Bahnen des zerstäubten und sich von der Zerstäubungsfläche zum Substrat bewegenden Materials angeordneten Anode gezeigt.

In der genannten Patentschrift wird vorgeschlagen, daß die zu zerstäubende und dem zu besprühenden Substrat zugewandte Katodenoberfläche eben ist, daß sich das Substrat nahe dem Entladungsbereich parallel zu der ebenen Zerstäubungsfläche über diese hinwegbewegen läßt, und daß die das Magnetfeld erzeugende Magneteinrichtung auf der der ebenen Zerstäubungsfläche abgewandten Seite der Katode angeordnet ist.

Die Verwirklichung des der vorliegenden Erfindung zugrundeliegenden Prinzips ist nicht beschränkt auf eine Katodenzerstäubung der soeben beschriebenen Art. Der Gegenstand der Erfindung ist universell überall dort einsetzbar, wo es um die Regelung von reaktiven Sputterprozessen geht.

Der vorliegenden Erfindung liegen folgende Aufgaben zugrunde:

Die Regelung der reaktiven Zerstäubungsprozesse soll grundsätzlich verbessert werden. Es soll insbesondere ein stabiler Sputterbetrieb gewährleistet werden, d.h. der Betrieb soll in oder in der Nähe eines Arbeitspunkts auf der physikalischen Kennlinie stabil bleiben.

Der Sputterbetrieb soll arcingfrei (lichtbogenfrei) sein. Während des Sputtervorgangs soll weiterhin eine hohe Sputterrate aufrechterhalten werden.

Schließlich soll der Gegenstand der Erfindung universell einsetzbar sein, und zwar bei den oben beschriebenen Gleichspannungszerstäubungsverfahren (DC-Sputtern), Hochfrequenzzerstäubungsverfahren (HF-Sputtern), bei einem kombinierten DC-/HF-Sputtern, beim Sputtern mit Mittelfrequenzen (kHz-Bereich) sowie beim Sputtern mit oder ohne Bias (Vorspannung).

Die gestellten Aufgaben werden erfindungsgemäß dadurch gelöst, daß der durch den Wert einer der beiden die elektrische Leistungsaufnahme des reaktiven Sputterprozesses bestimmenden Faktoren, Arbeitsspannung oder Arbeitsstromstärke, definierte Arbeitspunkt auf der physikalischen Kennlinie Katodenspannung, bzw. Arbeitsstromstärke, über Reaktivgasfluss der Sputteranlage durch Dosierung des in die Prozesskammer eingeleiteten Reaktivgases, beispielsweise $O_2$, eingestellt und konstant oder annähernd konstant gehalten wird. Die gesamte Sputterleistung, $P = I \times U$, wird dabei von der Leistungsversorgungseinrichtung konstant gehalten.

Im einzelnen wird vorgeschlagen, daß der durch den Wert der Arbeitsspannung (Entladespannung) definierte Arbeitspunkt der Sputteranlage durch Dosierung des in die Prozesskammer eingeleiteten Reaktivgases, beispielsweise $O_2$, eingestellt und konstant bzw. annähernd konstant gehalten wird.

Alternativ kann vorgesehen werden, daß der durch den Wert der Arbeitsstromstärke definierte Arbeitspunkt der Sputteranlage durch Dosierung des in die Prozesskammer eingeleiteten Reaktivgases, beispielsweise $O_2$, eingestellt und konstant bzw. annähernd konstant gehalten wird.

Ergänzend wird vorgeschlagen, daß bei reaktiven Sputterprozessen, bei denen die aufgesputterten Schichten chemische Verbindungen, z.D. $Al_2O_3$, $SiO_2$, umfassen, die eine Sekundärelektronenausbeute haben, die höher ist als die der metallischen Komponenten, z.B. Al, Si, der chemischen Verbindungen, eine Regelcharakteristik bei der Reaktivgasdosierung angewendet wird, die durch eine abfallende Entladespannung-Reaktivgasfluss-Regelkennlinie charakterisiert wird, das heißt für die Regelkennlinie wird eine sinkende Entladespannung mit zunehmendem Reaktivgasfluss vorgegeben.

Zur letztgenannten Ausführung kann als Alternative vorgesehen werden, daß bei reaktiven Sputterprozessen, bei denen die aufgesputterten Schichten chemische Verbindungen, z.B. $Al_2O_3$, $SiO_2$, umfassen, die eine Sekundärelektronenausbeute haben, die höher ist als die der metallischen Komponenten, z.B. Al, Si, der chemischen Verbindungen, eine Regelcharakteristik bei der Reaktivgasdosierung angewendet wird, die durch eine steigende Entladestrom-Reaktivgasfluss-Regelkennlinie charakterisiert wird, das heißt für die Regelkennlinie wird ein steigender Entladestrom mit zunehmendem Reaktivgasfluss vorgegeben.

Zum Gegenstand der Erfindung gehört weiterhin, daß bei reaktiven Sputterprozessen, bei denen die aufgesputterten Schichten chemische Verbindungen, z.B. CrO, umfassen, die eine Sekundärelektronenausbeute haben, die kleiner ist als die der metallischen Komponenten, z.B. Cr, der chemischen Verbindungen, eine Regelcharakteristik bei der Reaktivgasdosierung angewendet wird, die durch eine steigende Entladespannung- Reaktivgasfluss-Regelkennlinie charakterisiert wird, das heißt für die Regelkennlinie wird eine steigende Entladespannung mit zunehmendem Reaktivgasfluss vorgegeben.

Alternativ hierzu wird vorgeschlagen, daß bei reaktiven Sputterprozessen, bei denen die aufgesputterten Schichten chemische Verbindungen, z.B. CrO, umfassen, die eine Sekundärelektronenausbeute haben, die kleiner ist als die der metallischen Komponenten, z.B. Cr, der chemischen Verbindungen, eine Regelcharakteristik bei der Reaktivgasdosierung angewendet wird, die durch eine abfallende Entladestrom-Reaktivgasfluss-Regelkennlinie charakterisiert wird, das heißt für die Regelkennlinie wird ein fallender Entladestrom mit zunehmendem Reaktivgasfluss vorgegeben.

Im einzelnen wird vorgesehen, daß die Katodenspannung als Ist-Wert, bzw. Eingangssignal, einer Regeleinrichtung zugeführt wird, daß die Regeleinrichtung das Eingangssignal zu einem Ausgangssignal verarbeitet, das als Stellgröße einem Stellglied in Form eines Regelventils für den Reaktivgaszufluss zugeführt wird, das den Reaktivgaszufluss dosiert.

Alternativ wird vorgeschlagen, daß die Stromstärke als Ist-Wert, bzw. Eingangssignal, einer Regeleinrichtung zugeführt wird, daß die Regeleinrichtung das Eingangssignal zu einem Ausgangssignal verarbeitet, das als Stellgröße einem Stellglied in Form eines Regelventils für den Reaktivgaszufluss zugeführt wird, das den Reaktivgaszufluss dosiert.

Zur Erfindung gehört weiterhin eine Vorrichtung zur Durchführung der oben beschriebenen Verfahren.

Im einzelnen wird hierzu vorgeschlagen, daß eine Sputteranlage vorgesehen ist, die eine Regeleinrichtung (Reaktivgasregler) und ein Regelventil für die Dosierung des Reaktivgases umfasst, daß eine Signalleitung vorgesehen ist, die die Katodenspannung zum Eingang der Regeleinrichtung führt, daß der Ausgang der Regeleinrichtung mit dem Regelventil über eine Leitung verbunden ist, die die Stellgröße, die in der Regeleinrichtung erarbeitet wurde, dem Regelventil zuführt.

Alternativ kann im Rahmen des Regelverfahrens anstelle mit der Katodenspannung in einem weiteren Ausführungsbeispiel mit dem Katodenstrom gearbeitet werden.

Durch die Erfindung werden folgende Vorteile erreicht: Es wird ein Sputterbetrieb im oder in der Nähe eines stabilen Arbeitspunkts gewährleistet. Der Sputterbetrieb ist arcingfrei. Während des Sputtervorgangs wird eine hohe Sputterrate aufrechterhalten.

Weitere Einzelheiten der Erfindung, der Aufgabenstellung und der erzielten Vorteile sind der folgenden Beschreibung eines Ausführungsbeispiels für eine Vorrichtung zur Durchführung der erfindungsgemäßen Verfahren zu entnehmen.

Diese Ausführungsbeispiel sowie die physikalischen Kennlinien eines reaktiven Sputterprozesses sowie die angewendeten Regelverfahren werden anhand von drei Figuren erläutert.

Figur 1 zeigt schematisch die Vorrichtung.

Figur 2 zeigt die Entladespannung in Abhängigkeit vom $O_2$-Fluss in Form einer Kurve.

Figur 3 zeigt den Entladestrom in Abhängigkeit vom $O_2$-Fluss in Form einer Kurve.

Mit der Vorrichtung sollen auf einem nicht dargestellten Substrat durch reaktives Sputtern Schichten hergestellt werden. Diese Schichten bestehen im vorliegenden Fall aus chemischen Verbindungen, beispielsweise aus $Al_2O_3$ oder $SiO_2$. Es wird von einem metallischen Target gesputtert, das aus Al, bzw. Si, besteht. Die Sputteratmosphäre besteht aus einem Gasgemisch, das Ar und als Reaktivgas $O_2$ aufweist.

Die Vorrichtung besitzt eine Regeleinrichtung, in der eine bestimmte Regelcharakteristik installiert ist. Diese Regeleinrichtung verarbeitet mit Hilfe der Regelcharakteristik die Katodenspannung als Eingangssignal zu einer Stellgröße am Ausgang der Regeleinrichtung. Diese Stellgröße wird einem Stellglied zugeführt, das als Regelventil für das Reaktivgas $O_2$ ausgebildet ist.

Aufgrund der installierten Regelcharakteristik wird der $O_2$-Zufluss in die Prozesskammer derart geregelt, daß die vorgegebene Entladespannung (Arbeitsspannung) konstant bleibt.

Bei Sputterprozessen, bei denen chemische Verbindungen, z.B. $Al_2O_3$, $SiO_2$, auf das Substrat aufgesputtert werden, die eine Sekundärelektronenausbeute haben, die größer ist als die der metallischen Komponenten z.B. Al, Si, wird eine Regelcharakteristik bei der Reaktivgasdosierung angewendet, die durch eine abfallende Entladespannung- Reaktivgasfluss-Regelkennlinie charakterisiert wird, das heißt für die Regelkennlinie wird eine abfallende Entladespannung mit zunehmendem Reaktivgasfluss vorgegeben.

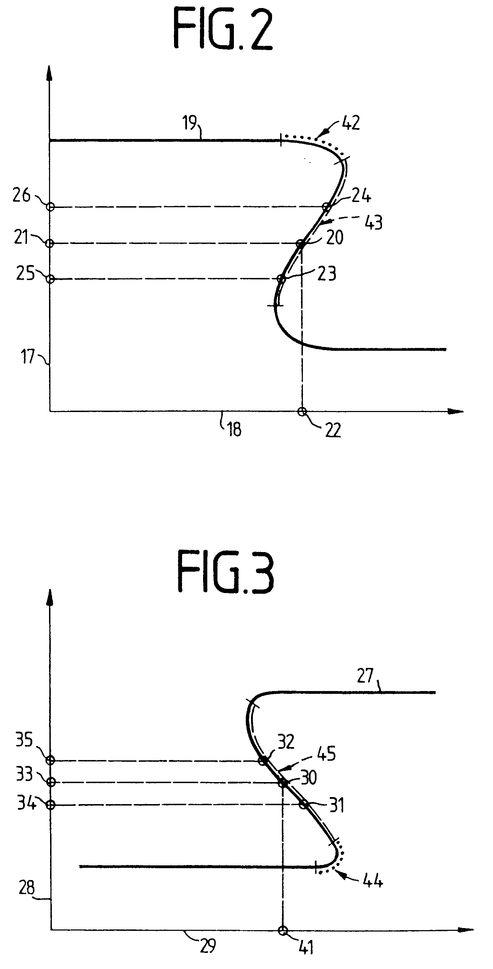

Die erfinderische Leistung besteht darin, daß ein Regelprinzip gefunden wurde, dessen Lehre im Gegensatz zur Aussage der physikalischen Kennlinien "Katodenspannung über $O_2$-Fluss", siehe Figur 2, bzw. "Stromstärke über $O_2$-Fluss", siehe Figur 3, steht und trotzdem in der Praxis funktioniert. Während ein Regeln entlang der physikalischen Kennlinien zum "Absturz" des Sputterprozesses führt.

Die Erfindung lehrt in ihrem Kern, daß der anzustrebende stabile Arbeitspunkt des Sputterprozesses durch die Reaktionsgasdosierung eingeregelt wird.

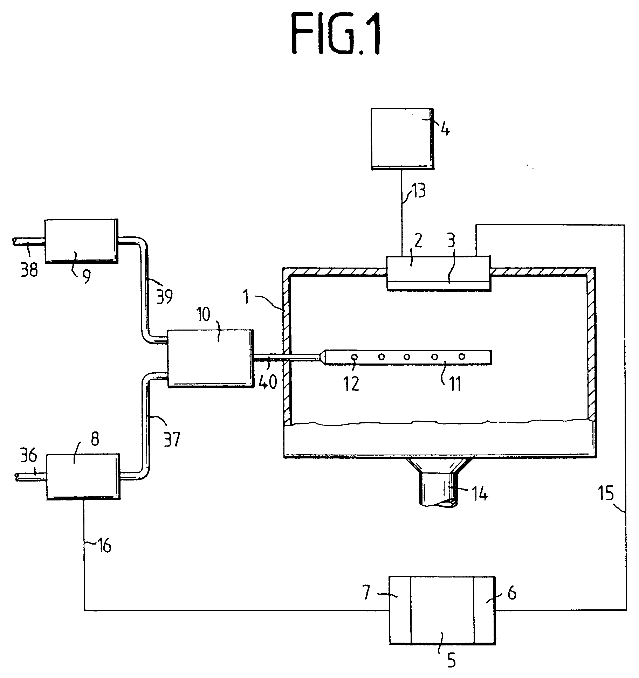

Die Figuren 2 und 3 werden weiter unten kommentiert werden. Zunächst wird der Aufbau der Sputteranlage anhand von Figur 1 beschrieben.

In Figur 1 ist mit 1 die Prozesskammer bezeichnet. 2 ist die Bezugsziffer für die Katode. Mit 3 ist das Target bezeichnet. 4 stellt die Energieversorgungseinheit dar. Es kann sich um eine DC-Stromversorgung oder um einen HF-Sender (Hochfrequenzsender) handeln. Es kann auch vorgesehen werden, daß eine Energiequelle, bestehend aus einer DC-Stromversorgung und einem HF-Sender, eingesetzt wird. Außerdem kann ein MF-Sender (Mittelfrequenzsender) vorgesehen werden.

Mit 5 ist eine Regeleinrichtung bezeichnet, in der eine Regelcharakteristik als Führungsgröße installiert ist. Mit 6 ist der Eingang der Regeleinrichtung gekennzeichnet. 7 stellt den Ausgang dar.

8 ist das Stellglied des Regelkreises in Form eines Regelventils für Reaktivgas. Mit 9 ist ein Flowmeter für Argon bezeichnet. 10 ist die Bezugsziffer für den Gasmischer. Innerhalb der Prozesskammer 1 befinden sich Austrittsöffnungen für das Gasgemisch, bestehend aus $O_2$ und Ar. Die Austrittsöffnungen sind je nach Erfordernis in einer Gasdusche oder Lanze oder in einer anderen geeigneten Vorrichtung angeordnet. Die Vorrichtung, die im vorliegenden Fall eine Lanze ist, trägt in Figur 1 die Bezugsziffer 11. Eine der Öffnungen der Gaslanze ist mit 12 bezeichnet. Über die Vakuumleitung 14 wird die Prozesskammer auf das notwendige niedrige Betriebsdruckniveau gebracht.

Mit 36 ist die Zuleitung für das Reaktivgas $O_2$ bezeichnet. 37 ist eine Leitung, die den durch die Regelung dosierten $O_2$-Fluss zum Gasmischer 10 führt.

Mit 38 ist die Zuleitung für Argon bezeichnet. 39 ist die Verbindungsleitung zwischen dem Flowmeter 9 und dem Gasmischer 10. Mit 40 ist die Verbindungsleitung zwischen Gasmischer und der Gasdusche bzw. Gaslanze 11 bezeichnet.

Nicht dargestellt sind aus Vereinfachungsgründen und, weil allgemein bekannt, das Substrat und die auf dem Substrat aufwachsende Schicht, die beispielsweise aus $Al_2O_3$ bestehen kann.

Während des Sputterprozesses herrscht in der Prozesskammer eine $Ar/O_2$-Atmosphäre, also eine reaktive Atmosphäre.

Die für den Sputterprozess benötigte elektrische Leistung P, die das Produkt aus Spannung U und Stromstärke I darstellt, wird von der Versorgungseinheit 4 unter anderem über die Leitung 13 der Katode 2 zugeführt. Weitere unter Umständen notwendige Leistungsleitungen wurden aus Vereinfachungsgründen und um die Darstellung übersichtlich zu gestalten fortgelassen. Während des Sputterprozesses befindet sich in der Prozesskammer ein Plasma, siehe hierzu die zahlreichen Veröffentlichungen zum Stande der Technik.

Über die Leitung 15 wird die Katodenspannung dem Eingang 6 der Regeleinrichtung 5 (Reaktivgasregler) zugeführt. Aufgrund der in der Regeleinrichtung installierten Führungsgröße (Regelcharakteristik) wird das am Eingang 6 zur Verfügung gestellte Signal in der Regeleinrichtung verarbeitet, und zwar zu einer Stellgröße, die am Ausgang 7 der Regeleinrichtung zur Verfügung gestellt wird. Über die Leitung 16 wird diese Stellgröße dem Stellglied (Regelventil) für den $O_2$-Fluss zugeführt. Der $O_2$-Fluss wird somit entsprechend der installierten Regelcharakteristik dosiert.

Zum Verständnis der nachfolgend beschriebenen Vorgänge und des Sputterprozesses generell sind folgende Erläuterungen notwendig.

Während des Sputtervorgangs bilden sich Oxide, beispielsweise $Al_2O_3$ oder $SiO_2$. An die Stelle von $Al_2O_3$ oder $SiO_2$ können auch andere Oxide oder chemische Verbindungen treten. Die Oxide bilden einmal die auf dem Substrat aufwachsende Schicht und zum anderen überziehen sie während des Sputterprozesses die Targetoberfläche in einem mehr oder weniger großen Bereich. Der Überzug, bzw. die Abdeckung, beginnt sich auf den nichterodierten Bereichen der Targetoberfläche zu bilden und wächst je nach Prozessparameter mehr oder weniger in die erodierten Bereiche der Targetoberfläche.

Nachfolgend wird davon ausgegangen, daß die chemische Verbindung der aufwachsenden Schicht $Al_2O_3$ ist und das als Reaktivgas $O_2$ eingesetzt wird.

Je nachdem wie weit die Targetoberfläche mit Oxid bedeckt ist, wird sich eine mehr oder weniger große Sekundärelektronenausbeute einstellen. Wird mehr Reaktivgas, $O_2$, eingeleitet, ergibt sich eine größere Abdeckung des Targets durch $Al_2O_3$. Je größer die Abdeckung des Targets ist, umso größer ist die Sekundärelektronenausbeute. Eine größere Sekundärelektronenausbeute bedeutet einen größeren Entladestrom I. Bei konstant behaltener Leistungsaufnahme P ist dies gleichbedeutend mit einer fallenden Entladespannung U, denn $P_{konstant}$ = U x I.

Weitere Einzelheiten zu den physikalischen und chemischen Grundlagen der hier beschriebenen Vorgänge sind der Fachliteratur zu entnehmen.

Anhand der Figuren 2 und 3 werden nachfolgend das Regelparadoxon, d.h. der Gegensatz zwischen den physikalischen Kennlinien einerseits und den installierten Regelcharakteristiken andererseits, erläutert. Im Definieren dieser Regelcharakteristika entgegen der Lehre der physikalischen Kennlinien liegt, wie eingangs erwähnt, die erfinderische Leistung.

In Figur 2 ist ein Koordinatensystem dargestellt. Auf der Ordinate 17 ist die Katodenspannung U eingetragen. Die Abzisse 18 trägt die Werte für den $O_2$-Fluss. Die Kurve 19 ist die physikalische Kennlinie "Katodenspannung über $O_2$-Fluss". Mit 20 ist der Arbeitspunkt, Soll-Punkt der Regelung, auf der Kurve bezeichnet. 21 ist die dazugehörende Spannung, Soll-Spannung, $U_{Soll}$, und 22 der dazugehörende $O_2$-Fluss. Mit 23 ist ein Ist-Punkt, der unterhalb des Soll-Punkts liegt, bezeichnet. 24 ist ein zweiter Ist-Punkt, der oberhalb des Soll-Punkts liegt. Diesen beiden Ist-Punkten sind die beiden Ist-Spannungen, $U_{Ist-1}$, $U_{Ist-2}$, 25, 26 zugeordnet. Obwohl nach der physikalischen Entladespannung-Reaktivgasfluss-Kennlinie in Figur 2 in den für das reaktive Sputtern interessierenden Kennlinienbereichen 42, gekennzeichnet durch eine parallel laufende, punktierte Begleitlinie, und 43, gekennzeichnet durch eine parallel laufende, gestrichelte Begleitlinie, zwei gänzlich unterschiedliche Kennlinienverläufe vorliegen, ist zur Kontrolle des Prozesses in beiden Bereichen nur eine Regelcharakteristik anzuwenden, nämlich diejenige der fallenden Kennlinie, das heißt im Kennlinienbereich 43, wo vorwiegend der interessierende Arbeitspunkt liegt, muß entgegen der physikalischen Kennlinie nach einer Regelcharakteristik geregelt werden, die einer fallenden Kennlinie entspricht (scheinbares Regelparadoxon).

Nachfolgend wird das Regelverhalten für $U_{Ist}$ kleiner als $U_{Soll}$ beschrieben:

1. Die Regeleinrichtung vergleicht $U_{Ist}$ mit $U_{Soll}$ und stellt fest, daß $U_{Ist-1}$, Bezugsziffer 25, kleiner ist als $U_{Soll}$.

2. Im Widerspruch zur physikalischen Kennlinie nimmt der Regler den $O_2$-Fluss zurück. Dadurch wird folgendes bewirkt:

   a) die Oxidschicht auf der Targetoberfläche bildet sich zurück,

   b) damit sinkt die Sekundärelektronenausbeute, d.h. die Stromstärke I verringert sich,

   c) damit steigt, da $P_{konstant}$ = U x I, die Entladespannung an und zwar bis über $U_{Soll}$ auf den Wert $U_{Ist-2}$, Bezugsziffer 26.

3. Der Regler vergleicht $U_{Ist-2}$ mit $U_{Soll}$ und stellt fest, daß $U_{Ist-2}$ größer ist als $U_{Soll}$.

4. Der Regler erhöht den $O_2$-Fluss.

5. Der Oxidbelag auf der Targetoberfläche wird größer.

6. Die Sekundärelektronenausbeute steigt, damit steigt die Stromstärke.

7. Wegen $P_{konstant}$ = U x I fällt die Spannung und nähert sich, bzw. erreicht dem bzw. den Wert $U_{Soll}$.

Fazit: Durch die Regelung des $O_2$-Flusses wird der Arbeitspunkt 20, bzw. $U_{Soll}$, eingestellt.

In Figur 3 ist die physikalische Kennlinie "Stromstärke I über $O_2$-Fluss" als Kurve 27 dargestellt.

Auf der Ordinate 28 sind die Werte für die Stromstärke und auf der Abzisse 29 die Werte für den $O_2$-Fluss eingetragen. 30 ist der Arbeitspunkt. 31 und 32 sind Ist-Punkte auf der Kurve. Dem Arbeitspunkt 30 zugeordnet ist der Arbeitsstrom 33 und der Wert 41 des $O_2$-Flusses. Dem Ist-Punkt 31 ist der Ist-Strom 34 und dem Ist-Punkt 32 der Ist-Strom 35 zugeordnet. Obwohl nach der physikalischen Entladestrom-Reaktivgasfluss-Kennlinie in Figur 3 in den für das reaktive Sputtern interessierenden Kennlinienbereichen 44, gekennzeichnet durch eine parallel laufende, punktierte Begleitlinie, und 45, gekennzeichnet durch eine parallel laufende, gestrichelte Begleitlinie, zwei gänzlich unterschiedliche Kennlinienverläufe vorliegen, ist zur Kontrolle des Sputterprozesses in beiden Bereichen nur eine Regelcharakteristik anzuwenden, nämlich diejenige der steigenden Kennlinie, das heißt im Kennlinienbereich 45, wo vorwiegend der interessierende Arbeitspunkt liegt, muß entgegen der physikalischen Kennlinie nach einer Regelcharakteristik geregelt werden, die einer steigenden Kennlinie entspricht (scheinbares Regelparadoxon).

Nachfolgend die Beschreibung des Regelverhaltens für $I_{Ist}$ kleiner als $I_{Soll}$:

1. Regler vergleicht $I_{Ist}$ mit $I_{Soll}$ und stellt fest, daß $I_{Ist-1}$, Bezugsziffer 34, kleiner ist als $I_{Soll}$.

2. Im Widerspruch zur physikalischen Kennlinie erhöht der Regler den $O_2$-Fluss. Dadurch wird

folgendes bewirkt:

a) die Oxidschicht auf der Targetoberfläche wächst weiter,

b) damit wächst die Sekundärelektronenausbeute, d.h. die Stromstärke I vergrößert sich,

c) damit steigt, da $P_{konstant}$ = U x I, der Entladestrom und zwar bis über $I_{Soll}$ auf den Wert $I_{Ist-2}$, Bezugsziffer 35.

3. Der Regler vergleicht $I_{Ist-2}$ mit $I_{Soll}$ und stellt fest, daß $I_{Ist-2}$ größer ist als $I_{Soll}$.

4. Der Regler reduziert den $O_2$-Fluss.

5. Der Oxidbelag auf der Targetoberfläche wird reduziert.

6. Die Sekundärelektronenausbeute wird reduziert, damit fällt die Stromstärke.

7. Die Ist-Stromstärke nähert sich der Soll-Stromstärke und wird schließlich zur Soll-Stromstärke.

Fazit: Durch die Regelung des $O_2$-Flusses wird der Arbeitspunkt 30, bzw. $I_{Soll}$, eingestellt.

Beim Sputtern von Schichten, die aus chemischen Verbindungen, z.B. CrO, bestehen, deren Sekundärelektronenausbeuten kleiner sind als die Sekundärelektronenausbeute der entsprechenden metallischen Komponenten, z.B. Cr, werden im Rahmen der vorliegenden Erfindung die Katodenspannungs-/Reaktivgasflußregelcharakteristika, bzw. die Katodenstrom-/Reaktivgasflußregelcharakteristika, vorgeschlagen, die wegen der umgekehrt verlaufenden Sekundärelektronenausbeute entsprechend umgekehrt ausgestaltet sind, und zwar umgekehrt in Hinsicht auf die Regelcharakteristika, bzw. Regelverfahren, die oben im Zusammenhang mit den Figuren 2 und 3 beschrieben wurden. Weitere Einzelheiten zu diesen, Regelverfahren sind in den oben wiedergegebenen Ansprüchen 7 und 8 und in der Beschreibungseinleitung wiedergegeben.

Liste der Einzelteile

1 Prozesskammer
2 Katode
3 Target
4 Energieversorgungseinheit
5 Regeleinrichtung
6 Eingang
7 Ausgang
8 Regelventil
9 Flowmeter
10 Gasmischer
11 Vorrichtung
12 Öffnung
13 Leitung
14 Vakuumleitung
15 Leitung
16 Leitung
17 Ordinate
18 Abzisse
19 Kurve
20 Arbeitspunkt
21 Spannung
22 $O_2$-Fluss, Wert
23 Ist-Punkt
24 Ist-Punkt
25 Ist-Spannung, $U_{Ist-1}$
26 Ist-Spannung, $U_{Ist-2}$
27 Kurve
28 Ordinate
29 Abzisse
30 Arbeitspunkt
31 Ist-Punkt
32 Ist-Punkt
33 Arbeitsstrom
34 Ist-Strom, $I_{Ist-1}$
35 Ist-Strom, $I_{Ist-2}$
36 Leitung
37 Leitung
38 Leitung
39 Leitung
40 Leitung
41 $O_2$-Fluss, Wert
42 Kennlinienbereich
43 Kennlinienbereich
44 Kennlinienbereich
45 Kennlinienbereich

**Patentansprüche**

1. Verfahren zur Regelung eines reaktiven Sputterprozesses, dadurch **gekennzeichnet**, daß der durch den Wert einer der beiden die elektrische Leistungsaufnahme des reaktiven Sputterprozesses bestimmenden Faktoren, Arbeitsspannung oder Arbeitsstromstärke, definierte Arbeitspunkt auf der physikalischen Kennlinie Katodenspannung bzw. Arbeitsstromstärke über dem Reaktivgasfluss der Sputteranlage durch Dosierung des in die Prozesskammer eingeleiteten Reaktivgases, beispielsweise $O_2$, eingestellt und konstant gehalten wird.

2. Verfahren zur Regelung eines reaktiven Sputterprozesses, dadurch **gekennzeichnet**, daß der durch den Wert einer der beiden die elektrische Leistungsaufnahme des reaktiven Sputterprozesses bestimmenden Faktoren, Arbeitsspannung oder Arbeitsstromstärke, definierte Arbeitspunkt auf der physikalischen Kennlinie Katodenspannung bzw. Arbeitsstromstärke über dem Reaktivgasfluss der Sputteranlage durch Dosierung des in die Prozesskammer eingeleiteten Reaktivgases, beispielsweise $O_2$, eingestellt und annähernd konstant gehalten wird.

3. Verfahren nach Anspruch 1 bzw. Anspruch 2, dadurch **gekennzeichnet**, daß der unter anderem durch den Wert der Arbeitsspannung (Entladespannung) definierte Arbeitspunkt der Sputteranlage durch Dosierung des in die Prozesskammer eingeleiteten Reaktivgases, beispielsweise $O_2$, eingestellt und konstant bzw. annähernd konstant gehalten wird.

4. Verfahren nach Anspruch 1 bzw. Anspruch 2, dadurch **gekennzeichnet**, daß der unter anderem durch den Wert der Arbeitsstromstärke definierte Arbeitspunkt der Sputteranlage durch Dosierung des in die Prozesskammer eingeleiteten Reaktivgases, beispielsweise $O_2$, eingestellt und konstant bzw. annähernd konstant gehalten wird.

5. Verfahren nach einem oder mehreren der vorangegangenen Ansprüche, dadurch **gekennzeichnet**, daß bei reaktiven Sputterprozessen, bei denen die aufgesputterten Schichten chemische Verbindungen, z.B. $Al_2O_3$, $SiO_2$, umfassen, die eine Sekundärelektronenausbeute haben, die höher ist als die der metallischen Komponenten, z.B. Al, Si, der chemischen Verbindungen, eine Regelcharakteristik bei der Reaktivgasdosierung angewendet wird, die durch eine abfallende Entladespannung-Reaktivgasfluss-Regelkennlinie charakterisiert wird, das heißt für die Regelkennlinie wird eine abfallende Entladespannung mit zunehmenden Reaktivgasfluss vorgegeben.

6. Verfahren nach einem oder mehreren der vorangegangenen Ansprüche, dadurch **gekennzeichnet**, daß bei reaktiven Sputterprozessen, bei denen die aufgesputterten Schichten chemische Verbindungen, z.B. $Al_2O_3$, $SiO_2$, umfassen, die eine Sekundärelektronenausbeute haben, die höher ist als die der metallischen Komponenten, z.B. Al, Si, der chemischen Verbindungen, eine Regelcharakteristik bei der Reaktivgasdosierung angewendet wird, die durch eine steigende Entladestrom-Reaktivgasfluss-Regelkennlinie charakterisiert wird, das heißt für die Regelkennlinie wird ein steigender Entladestrom mit zunehmendem Reaktivgasfluss vorgegeben.

7. Verfahren nach einem oder mehreren der vorangegangenen Ansprüche, dadurch **gekennzeichnet**, daß bei reaktiven Sputterprozessen, bei denen die aufgesputterten Schichten chemische Verbindungen, z.B. CrO, umfassen, die eine Sekundärelektronenausbeute haben, die kleiner ist als die der metallischen Komponenten, z.B. Cr, der chemischen Verbindungen, eine Regelcharakteristik bei der Reaktivgasdosierung angewendet wird, die durch eine steigende Entladespannung-Reaktivgasfluss-Regelkennlinie charakterisiert wird, das heißt für die Regelkennlinie wird eine steigende Entladespannung mit zunehmendem Reaktivgasfluss vorgegeben.

8. Verfahren nach einem oder mehreren der vorangegangenen Ansprüche, dadurch **gekennzeichnet**, daß bei reaktiven Sputterprozessen, bei denen die aufgesputterten Schichten chemische Verbindungen, z.B. CrO, umfassen, die eine Sekundärelektronenausbeute haben, die kleiner ist als die der metallischen Komponenten, z.B. Cr, der chemischen Verbindungen, eine Regelcharakteristik bei der Reaktivgasdosierung angewendet wird, die durch eine abfallende Entladestrom-Reaktivgasfluss-Regelkennlinie charakterisiert wird, das heißt für die Regelkennlinie wird ein fallender Entladestrom mit zunehmendem Reaktivgasfluss vorgegeben.

9. Verfahren nach einem oder mehreren der vorangegangenen Ansprüche, dadurch **gekennzeichnet**, daß die Katodenspannung als Ist-Wert, bzw. Eingangssignal, einer Regeleinrichtung (5) zugeführt wird, daß die Regeleinrichtung das Eingangssignal zu einem Ausgangssignal verarbeitet, das als Stellgröße einem Stellglied in Form eines Regelventils (8) für den Reaktivgaszufluss zugeführt wird, das den Reaktivgaszufluss dosiert.

10. Verfahren nach einem oder mehreren der vorangegangenen Ansprüche, dadurch **gekennzeichnet**, daß die Stromstärke als Ist-Wert, bzw. Eingangssignal, einer Regeleinrichtung zugeführt wird, daß die Regeleinrichtung das Eingangssignal zu einem Ausgangssignal verarbeitet, das als Stellgröße einem Stellglied in Form eines Regelventils für den Reaktivgaszufluss zugeführt wird, das den Reaktivgaszufluss dosiert.

11. Vorrichtung zur Durchführung eines Verfahrens nach einem oder mehreren der vorangegangenen Ansprüche, dadurch **gekennzeichnet**, daß eine Sputteranlage vorgesehen ist, die eine Regeleinrichtung (Reaktivgasregler) (5) und ein Regelventil (8) für die Dosierung des Reaktivgases umfasst, daß eine Signalleitung (15) vorgesehen ist, die die Katodenspannung zum Eingang der Regeleinrichtung führt, daß der Ausgang der Regeleinrichtung mit dem Regelventil (8) über eine Leitung verbunden ist, die die Stellgröße, die in der Regeleinrichtung erarbeitet wurde, dem Regelventil zuführt.

12. Vorrichtung zur Durchführung eines Verfahrens nach einem oder mehreren der vorangegangenen Ansprüche, dadurch **gekennzeichnet**, daß eine Sputteranlage vorgesehen ist, die eine Regeleinrichtung (Reaktivgasregler) und ein Regelventil für die Dosierung des Reaktivgases umfasst, daß eine Signalleitung vorgesehen ist, die die Stromstärke zum Eingang der Regeleinrichtung führt, daß der Ausgang der Regeleinrichtung mit dem Regelventil über eine Leitung verbunden ist, die die Stellgröße, die in der Regeleinrichtung erarbeitet wurde, dem Regelventil zuführt.

# FIG.1

# FIG.2

# FIG.3

Europäisches
Patentamt

**EUROPÄISCHER RECHERCHENBERICHT**

Nummer der Anmeldung

EP    91 11 8409

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | DD-A-146 306 (BEISTER ET AL.)<br>* Ansprüche 1-6; Abbildung 1 *<br>--- | 1-8 | C23C14/34<br>C23C14/54 |
| X | GB-A-2 021 294 (LEYBOLD HERAEUS)<br><br>* Seite 1, Zeile 50 - Zeile 54; Ansprüche 1,2 *<br>--- | 1,2,4,<br>10,12 | |
| X | US-A-4 201 645 (RIEGERT)<br>* Ansprüche 1,4,10,11 *<br>--- | 1-3,9,11 | |
| A | APPLIED PHYSICS A. SOLIDS AND SURFACES.<br>Bd. A51, Nr. 5, November 1990, HEIDELBERG DE<br>Seiten 423 - 426;<br>RAO ET AL.: 'Preparation and Characterization of Cu-Cu2O Cermet Films'<br>* Seite 424, Spalte 2, Zeile 19 - Seite 425, Spalte 1, Zeile 8 *<br><br>----- | 5-8 | |

**RECHERCHIERTE SACHGEBIETE (Int. Cl.5)**

C23C

Der vorliegende Recherchenbericht wurde für alle Patentansprüche erstellt

| Recherchenort | Abschlußdatum der Recherche | Prüfer |
|---|---|---|
| DEN HAAG | 05 JUNI 1992 | PATTERSON A.M. |